Europäisches Patentamt

(19) European Patent Office

Office européen des brevets

(11) EP 0 935 284 A1

(12) **EUROPEAN PATENT APPLICATION**

(43) Date of publication:
11.08.1999 Bulletin 1999/32

(21) Application number: 98101539.9

(22) Date of filing: 29.01.1998

(51) Int. Cl.$^6$: **H01L 21/316**, H01L 21/314,
H01L 21/318, H01L 21/285,
H01L 21/205

(84) Designated Contracting States:
AT BE CH DE DK ES FI FR GB GR IE IT LI LU MC
NL PT SE
Designated Extension States:
AL LT LV MK RO SI

(71) Applicant: Hwang, Chul-Ju
Sungnam-Shi, Kyungki-Do (KR)

(72) Inventor: Hwang, Chul-Ju
Sungnam-Shi, Kyungki-Do (KR)

(74) Representative:
Dost, Wolfgang, Dr.rer.nat., Dipl.-Chem. et al
Patent- und Rechtsanwälte
Bardehle . Pagenberg . Dost . Altenburg .
Geissler . Isenbruck
Postfach 86 06 20
81633 München (DE)

(54) **CVD of silicon containing film using Si2H6**

(57) A method of forming a thin film for a semiconductor device which applies disilane ($Si_2H_6$) to chemical vapor deposition is capable of improving deposition rate and step coverage of the thin film although the thin film is deposited at lower temperatures, thereby improving productivity and reliability of the semiconductor device. In order to form various thin films, $Si_2H_6$ and $N_2O$, or $Si_2H_6$ and $O_2$ are applied for an oxide film, $Si_2H_6$ and $NH_3$ for a nitride film, $Si_2H_6$, $N_2O$, and $NH_3$ for a nitride-oxide film, $Si_2H_6$, $O_2$, and $PH_3$ or TMOP for a PSG film, and $Si_2H_6$, $O_2$, $B_2H_6$ or TMOB, and $PH_3$ or TMOP for a BPSG film. Also, a system for the method according to the present invention is used among an atmospheric pressure chemical vapor deposition system, low pressure chemical vapor deposition system, and plasma chemical vapor deposition system.

FIG. 1

**Description**

BACKGROUND OF THE INVENTION

1. Field of the Invention

The present invention relates to a thin film applied to a semiconductor device, and in particular to an improved method of forming a thin film for a semiconductor device, which applies disilane ($Si_2H_8$) to chemical vapor deposition, capable of improving deposition rate and step coverage of the thin film although the thin film is deposited at low temperature.

2. Description of the Conventional Art

Generally, a fabrication process for a semiconductor device mainly includes forming a thin film, and patterning the thin film. The thin film which is provided in order to fabricate the semiconductor device may be divided into insulating film, dielectric film, conductive film, planarized film, and passivation film, etc. according to requirements. Most common materials for the dielectric film are Silicon oxide ($SiO_2$) and silicon nitride ($Si_3N_4$), for the conduction film are polysilicon and tungsten silicide ($WxSiy$), for the insulation film are silicon oxide ($SiO_2$) and phospho silicate glass (PSG), for the planarized film are phospho silicate glass (PSG) and borophospho silicate glass (BPSG), and silicon nitride is applied for the protection film.

Among methods for depositing the thin film, that is, physical deposition, vacuum deposition, chemical vapor deposition (CVD), and sputtering, etc., the CVD is the most common method. According to the CVD for forming the thin film, material gas is induced onto a substrate, and particles reacted on the substrate or in vapor are diffused on the surface of the substrate. The most common CVD equipments are atmospheric pressure chemical vapor deposition (APCVD) equipment, low pressure chemical vapor deposition (LPCVD) equipment, and plasma-enhanced chemical vapor deposition (PECVD or plasma deposition) equipment.

First, the APCVD applying the atmospheric pressure chemical vapor deposition (AFCVD) equipment, which has been firstly developed for forming a polysilicon layer for a bipolar device, deposits a polysilicon thin film by pyrolyzing polysilicon ($SiH_4$) at atmospheric pressure, 760 torr, at low temperature. The APCVD equipment performs the APCVD at low temperature and has a fast deposition rate, but has nonconformal step coverage and a high contamination possibility of particles by gaseous reaction. The APCVD, the most common CVD technique, is mainly applied to silicon oxide ($SiO_2$), phospho silicate glass (PSG), borophospho silicate glass (BPSG), or polysilicon epitaxy deposition.

The low pressure chemical vapor deposition (LPCVD) applying the LPCVD equipment has improved step coverage compared to the APCVD and a thickness uniformity of the thin film, but has a slow deposition rate, thus dropping mass productivity, and requires high temperature. The LPCVD is applied to polysilicon, silicon oxide ($SiO_2$), oxide nitride (SiOxNy), phospho silicate glass (PSG), or borophospho silicate glass (BPSG) deposition. To improve the defects of the LPCVD equipment which is processed at high temperature, there has been provided the plasma-enhanced chemical vapor deposition (PECVD) equipment. The PECVD equipment applies an energy for reaction acceleration to material gas as well as heat in order to avoid the high temperature process. The PECVD using the PECVD equipment is performed at low temperature by discharging electricity in a reaction chamber at reduced pressure (about 10-100Pa) for the reaction acceleration, thereby discharging plasma and exciting gaseous molecules into activation state. The most common plasma CVD is to generate the plasma by applying high frequency to a parallel-plate type electrode. Here, a frequency range for generating the plasma is between 50KHz and 15.56MHz. Since the PECVD is relatively performed at low temperatures and has a rapid deposition rate, it is most widely used thereamong.

When forming thin films such as oxide film, polysilicon film, tungsten silicide film, phospho silicate glass (PSG) film, and borophospho silicate glass (BPSG) film, etc., polysilicon ($SiH_4$) or tetra-ethyl-ortho-silicate (TEOS) is generally used as material gas. Table 1 shows the deposition conditions- material gas, temperature, and pressure- by each CVD equipment. Table 2 shows the step coverage and deposition rate of each thin film which is deposited in accordance with Table 1. That is, in order to form a conventional oxide film, material gases among TEOS and $O_2$, TEOS and $O_3$, $SiH_4$ and $N_2O$, or $SiH_4$ and $O_2$, are applied regardless of any kind of the CVD equipments. The temperature and pressure applied to each CVD equipment are as shown in Table 1. Namely, in case of the LPCVD equipment, the thin film is deposited under about 1.0 torr at about 430 to 800°C, and in the PECVD equipment, the thin film is deposited under 3.0 torr at temperature lower than 450°C. Also, the APCVD equipment performs the deposition at atmospheric pressure at temperature lower than 450°C.

In addition, dischlorosilane ($SiH_2Cl_2$) and $NH_3$, or $SiH_4$ and $NH_3$ are used for depositing the nitride film. Here, the LPCVD equipment has the conditions of about 700°C and 0.4 torr, and the PECVD equipment has the conditions of temperatures lower than 450°C and pressures lower than 3.0 torr.

In order to form the PSG or BPSG film which is the planarized film, TEOS, $O_2$ or $O_3$, and $PH_3$ or tetra-methyl-ortho-phosphorus (TMOP); and TEOS, $O_2$ or $O_3$, $B_2H_6$ or tetra-methyl-ortho-boron (TMOB), and $PH_3$ or TMOP are applied to material gases, respectively. In case of the LPCVD equipment, the deposition is performed at 1.0 to 4.0 torr at 610 to 700°C, and the PECVD equipment has the conditions of temperatures lower than about 450°C and pressures below 3.0 torr, the APCVD equipment has the condition of temperatures lower than 450°C. Here, in the Tables 1 and 2, the gas in the bracket, (), may replace the gas outside the bracket. That is, in case of $O_2(O_3)$, $O_3$ may replace $O_2$.

[Table.1]

| | gas | deposition method | | | | | |
|---|---|---|---|---|---|---|---|
| | | LPCVD | | PECVD | | APCVD | |
| | | temparature (°C) | pressu-re (torr) | tempar-ature (°C) | pressu-re (torr) | tempar-ature (°C) | pressu-re (torr) |
| oxide film | TEOS/$O_2$ | ≈700 | ≈0.3 | ≤450 | ≤3.5 | ≤450 | atmos-pheric pres-sur-e |
| | SiH$_4$/N$_2$O | ≈800 | ≈1.0 | ≤450 | ≤3.0 | x | x |
| | SiH$_4$/O$_2$ | ≈430 | ≈0.3 | x | x | ≤450 | atmos-pheric pres-sur-e |
| nitride film | DCS/NH$_3$ | ≈700 | ≈0.4 | x | x | x | x |
| | SiH$_4$/NH$_3$ | ≈700 | ≈0.4 | ≤450 | ≤3.0 | x | x |
| BPSG | TEOS/O$_2$(0$_3$)/PH$_3$(TMO P)/TMOB | ≈610 | ≈1.0 | ≤450 | 2.3-2.8 | ≤450 | atmos-pheric pres-sur-e |
| W$_x$Sly | SiH$_4$/WF$_6$ | 200~650 | 0.2~2 | x | x | x | x |

[Table.2]

| | gas | deposition method | | | | | |
|---|---|---|---|---|---|---|---|
| | | LPCVD | | PECVD | | APCVD | |
| | | deposition rate (Å/min) | step coverag-e (%) | deposition rate (Å/min) | step coverag-e (%) | deposition rate (Å/min) | step coverag-e (%) |
| oxide film | TEOS/$O_2$ | ≈100 | ≈90 | 3000 -8000 | ≤60 | ≤4000 | ≤60 |
| | SiH$_4$/N$_2$O | ≤30 | ≈100 | 3000 -8000 | ≤60 | x | x |
| | SiH$_4$/O$_2$ | ≈100 | ≤60 | x | x | ≈3000 | ≤60 |
| nitride film | DCS/NH$_5$ | ≈30 | ≈100 | x | x | x | x |
| | SiH$_4$/NH$_3$ | x | x | 3000 -8000 | ≤60 | x | x |
| BPSG | TEOS/O$_2$(0$_3$)/PH$_3$(TMO P)/TMOB | ≈200 | ≈80 | 3000 -5000 | ≈75 | 3000 -5000 | ≈80 |

However, when applying the conventional method of forming the thin film, that is, when using the method of forming the thin film according to the condition as shown in [Table.1], the thin film has slow deposition rate and low step coverage, as shown in [Table.2].

SUMMARY OF THE INVENTION

Accordingly, it is an object of the present invention to provide a method of forming a thin film for a semiconductor device capable of improving deposition rate and step coverage of a thin film by applying disilane ($Si_2H_6$) as material gas instead of $SiH_4$ or TEOS.
Additional advantages, objects and features of the invention will become more apparent from the description which follows.

BRIEF DESCRIPTION OF THE DRAWINGS

The present invention will become more fully understood from the detailed description given hereinbelow and the accompanying drawings which are given by way of illustration only, and thus are not limitative of the present invention, and wherein:

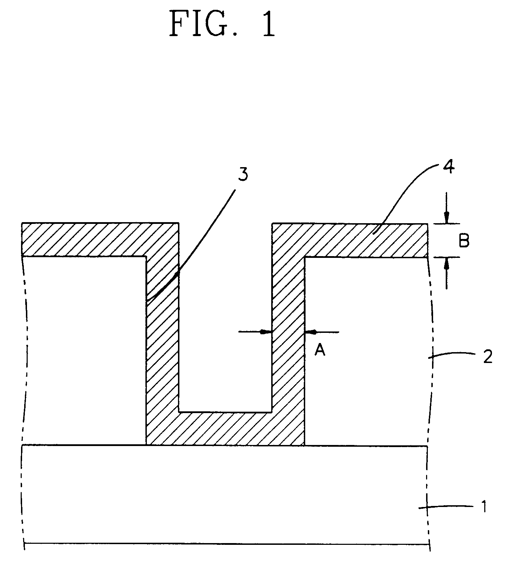

Figure 1 is a vertical cross-sectional view of a semiconductor substrate for illustrating step coverage.

DETAILED DESCRIPTION OF THE INVENTION

Table. 3 shows the conditions of a method of forming a thin film for a semiconductor device according to the present invention by each process equipment, and Table. 4 shows the deposition rate and step coverage of each thin film obtained under the condition as shown in Table.3. Here, the step coverage was observed as shown in Figure 1. That is, an insulating film 2 is formed on a semiconductor substrate 1, and a cavity 3 is made by etching a predetermined area of the insulating film 2. At this time, when a thickness of a portion of a thin film 4 which is fixed to a side wall of the cavity 3 is A and a thickness of a portion of the film 4 which is formed on an upper surface of the insulating film 2 is B, an equation of the step coverage is A / B x 100 = step coverage (%) . That is, when A and B has a same thickness, the step coverage is 100%, and higher step coverage is more suitable for a high-integrated semiconductor device.

[Table. 3]

| | gas | deposition method | | | | | |
|---|---|---|---|---|---|---|---|
| | | LPCVD | | PECVD | | APCVD | |
| | | temparature (°C) | pressu-re (torr) | tempar-ature (°C) | pressu-re (torr) | tempar-ature (°C) | pressu-re (torr) |
| oxide film | $Si_2H_6/N_2O$ | 500-800 | 0.1-9 | 150-750 | 0.1-9 | x | x |
| | $Si_2H_6/O_2$ | 300-700 | 0.1-9 | x | x | 200-650 | atmosph-eric pres-sur-e |
| nitride film | $Si_2H_6/NH_3$ | 350-800 | 0.1-9 | 150-750 | 0.1-9 | x | x |
| nitride -oxide film | $Si_2H_6/NH_3/N_2O$ | 350-800 | 0.1-9 | 150-750 | 0.1-9 | x | x |
| BPSG | $Si_2H_6/PH_3/O_2/TMOB$ | 250-800 | 0.1-9 | 150-750 | 0.1-9 | 200-650 | atmosph-eric pressur-e |
| | $Si_2H_6/TMOP/TMOB$ | 250-800 | 0.1-9 | 150-750 | 0.1-9 | 200-650 | atmos-pheric pres-sur-e |
| PSG | $Si_2H_6/O_2/PH_3$ (TMOP) | 200-700 | 0.1-9 | 150-750 | 0.1-9 | 200-650 | atmos-pheric pres-sur-e |
| $W_xSiy$ | $Si_2H_6/WF_6$ | 200-650 | 0.1-9 | x | x | x | x |

[Table.4]

| | gas | deposition method | | | | | |
|---|---|---|---|---|---|---|---|
| | | LPCVD | | PECVD | | APCVD | |
| | | deposition rate (Å/min) | step coverage (%) | deposit-ion rate (Å/min) | step coverage (%) | deposit-ion rate (Å/min) | step coverage (%) |
| oxide film | $Si_2H_6/N_2O$ | 15-500 | ≥95 | 50-9000 | ≥90 | x | x |
| | $Si_2H_6/O_2$ | 15-1000 | ≥90 | x | x | 500-5000 | ≥90 |
| nitride film | $Si_2H_6/NH_3$ | 5-500 | ≥95 | 50-9000 | ≥90 | x | x |
| BPSG | $Si_2H_6/PH_3(TMOP)/B_2H_6(TMOB)/O_2$ | 50-9000 | ≥90 | 50-9000 | ≥90 | 500-5000 | ≥90 |
| PSG | $Si_2H_6/O_2/PH_3(TMOP)$ | 50-6000 | ≥90 | 50-9000 | ≥90 | 500-5000 | ≥90 |

Now, the conditions of the method of forming the thin film according to the present invention by each process equipment will be described.

First, condition of a method of forming the thin film by using a LPCVD equipment will be described.

That is, an oxide ($SiO_2$) film was formed under condition below.

Temperatures in a reaction chamber ranged from 500 to 850°C, and pressures therein were between 0.1 and 9 torr. Disilane ($Si_2H_6$), main material gas, was flowed into the chamber at 10 to 400sccm, and $N_2O$ at 100 to 10000 sccm (Here, sccm is standard $cm^3$/min). At this time, more desirable ranges of temperatures and pressures are between 650 and 800°C and between 0.3 and 5 torr, respectively. When the oxide film was deposited under the above condition, the deposition rate thereof ranged from 15 to 500 Å/min, and the step coverage thereof was 95%.

In accordance with another method of forming the oxide film, temperatures and pressures in the reaction chamber ranged between 300 and 700°C and between 0.1 and 9 torr, respectively. Disilane ($Si_2H_6$) was flowed into the chamber at 10 to 500sccm and O2 at 20 to 1000sccm. Here, more desirable ranges of temperatures and pressures are between 300 and 550°C and between 0.1 and 5 torr, respectively. When the oxide film was deposited under the above condition, the deposition rate thereof ranged from 15 to 1000 Å/min, and the step coverage thereof was 90%.

The LPCVD applying disilane and $N_2O$, or disilane and $O_2$ according to the present invention shows that the deposition rate of the LPCVD according to the present invention is much improved compared with that of the conventional method using $SiH_4$ and $N_2O$, or $SiH_4$ and $O_2$, which were lower than 10 Å/min, and about 100 Å/min, respectively. In addition, the step coverage of the method of forming the oxide film according to the present invention was over 90%, while the step coverage according to the conventional method thereof applying $SiH_4$ and $O_2$ is about 60%. Additionally, even though the thin film was formed at lower temperatures by CVD according to the present invention, the result of the step coverage was still improved.

Next, a nitride ($Si_3N_4$) film was formed under condition below.

Temperatures in a reaction chamber ranged from 350 to 800°C, and pressures therein were between 0.1 and 9 torr. Disilane ($Si_2H_6$) was flowed into the chamber at 5 to 500sccm, and NH3 at 15 to 1000 sccm. At this time, more desirable ranges of temperatures and pressures are between 400 and 800°C and between 0.3 and 5 torr, respectively. When the nitride film was deposited under the above condition, the deposition rate thereof ranged from 5 to 500 Å/min, and the step coverage thereof was over 95%. The conventional method of depositing the nitride film applied dichlorine-silicate ($SiH_2Cl_2$) and $NH_3$, and temperature at 700°C and pressure at 0.4 torr in the reaction chamber. Here, the deposition rate thereof was 30 Å/min. According to the present invention, temperature applied to the method of forming the nitride film dropped from 700° to 350°C. However, the deposition rate of the thin film was much improved. Also, in spite of the process at a low temperature, the step coverage according to the present invention does not fall exceedingly.

A nitride-oxide ($SiOxNy$) film was formed under condition below.

Temperatures in a reaction chamber ranged from 350 to 800°C, and pressures therein were between 0.1 and 9 torr. Disilane and $NH_3$, or disilane and $N_2$ were applied to the deposition. At this time, more desirable ranges of temperatures and pressures are between 400 and 800°C and between 0.3 and 5 torr, respectively.

A BPSG film, the planarized film, was deposited under condition below.

Temperatures in a reaction chamber ranged from 350 to 800°C, and pressures therein were between 0.1 and

5

9 torr. Disilane was flowed into the chamber at 50 to 800sccm, and tetra-methyl-ortho-phosphorus (TMOP) or phosphine (PH$_3$) at 150 to 2400sccm, tetra-methyl-ortho-boron (TMOB) or diborane (B$_2$H$_6$) at 15 to 200sccm, and O$_2$ at 15 to 400sccm, thus forming the BPSG film. The deposition rate of the BPSG film obtained by the above condition according to the present invention was 50 to 9000 Å/min, showing much improvement compared to that of the conventional BPSG film obtained by the condition applying TEOS, O$_2$ or O$_3$, PH$_3$ or TMOP, and B$_2$H$_6$ or TMOB, which was 200 Å/min. Also, the step coverage of the BPSG film according to the present invention was 90% while the step coverage of the conventional BPSG film was 80%. Although the BPSG film was deposited at low temperature, the properties and growth rate of the thin film were improved.

A PSG film was deposited under condition that temperatures and pressures in the reaction chamber ranged between 200 and 700°C and between 0.1 and 9 torr, respectively. Disilane, and TMOP(PH$_3$) and O$_2$ were flowed into the reaction chamber at 50 to 800 sccm and at 15 to 500 sccm, respectively. Here, more desirable pressure range for depositing the PSG film according to the present invention is from 0.3 to 5 torr. Under the above condition, the deposition rate of the PSG film was 50 to 6000 Å/min, and the step coverage thereof was over 90%.

A tungsten silicide (WxSiy) film, which is widely applied to a gate electrode of a MOS memory device, was deposited at 0.1 to 9 torr and at temperatures ranged from 200 to 650°C by using disilane and WF$_6$. The thusly formed tungsten silicide film had lower resistance compared to the conventional tungsten silicide film using SiH$_4$ and WF$_6$, and higher step coverage than the conventional tungsten silicide film. Also, the tungsten silicide film according to the present invention had a big grain size.

Second, condition of a method of forming the thin film by using a PECVD equipment will be described.

An oxide (SiO$_2$) film was formed under such condition as follows. Temperatures in the reaction chamber ranged between 150 and 750°C, pressures were 0.1 to 9 torr, and disilane and N$_2$O were flowed into the chamber at 50 to 500sccm and 100 to 5000sccm, respectively. Here, more desirable pressures are 0.2 to 5.3 torr. The deposition rate of the oxide film was 50 to 9000 Å/min which was improved more than that of the conventional oxide film, 3000 to 8000 Å/min, and the step coverage was 90%, much improved than the conventional step coverage which was less than 60%.

Next, a nitride (Si$_3$N$_4$) film was deposited at 0.1 to 9 torr at temperatures ranged between 150 and 750°C. Also, disilane was flowed into the reaction chamber at 10 to 500sccm and ammonia (NH$_3$) at 15 to 2000sccm. At this time, more desirable pressures are 0.1 to 5.5 torr. According to the present invention, the deposition rate of the oxidation film was 50 to 9000 Å/min, and the step coverage was over 95%, which were both improved compared to the conventional method of forming the nitride film applying SiH$_4$ and NH$_3$.

A nitride-oxide (SiOxNy) film was deposited at pressures from 0.1 to 9 torr. Temperatures in the reaction chamber ranged between 150 and 750°C, and disilane and ammonia (NH$_3$) are flowed into the reaction chamber.

Next, a BPSG film was deposited under condition as follows.

Temperatures in the reaction chamber ranged from 250 to 800°C, and pressures therein were between 0.1 and 9 torr. Disilane was flowed into the chamber at 70 to 1000sccm, and tetra-methyl-ortho-phosphorus (TMOP) or phosphine (PH$_3$) at 150 to 3000sccm, tetra-methyl-ortho-boron (TMOB) or diborane (B$_2$H$_6$) at 15 to 300sccm, and O$_2$ at 15 to 500sccm, thus forming the BPSG film. The deposition rate of the BPSG film obtained by the above condition according to the present invention was 50 to 9000 Å/min, showing much improvement compared to that of the conventional BPSG film obtained by the condition applying TEOS, O$_2$ or O$_3$, PH$_3$ or TMOP, and B$_2$H$_6$ or TMOB, which was 3000 to 5000 Å/min. Also, the step coverage of the BPSG film according to the present invention was over 90% while the step coverage of the conventional BPSG film was about 75%.

A PSG film was deposited at pressures from 0.1 to 9 torr. Temperatures in the reaction chamber ranged between 150 and 700°C, and TMOP or PH$_3$, and O$_2$ were flowed into the reaction chamber at 50 to 1000sccm and at 15 to 500sccm, respectively. Here, the deposition rate of the PSG film according to the present invention was 50 to 9000 Å/min and the step coverage was over 90%.

Lastly, condition of a method of forming the thin film by using an APCVD equipment will be described.

An oxide (SiO$_2$) film was deposited at atmospheric pressure at 200 to 650°C, and disilane and O$_2$ were flowed into the reaction chamber. Here, the deposition rate of the oxide film according to the present invention ranged between 500 and 5000 Å/min, and the step coverage thereof was over 80%, showing much improvement compared to that of the conventional oxide film which was 60%.

A BPSG film was deposited at atmospheric pressure at 200 to 650°C, and disilane, TMOP or PH$_3$, TMOB or B$_2$H$_6$, and O$_2$ were respectively flowed into the reaction chamber. Here, the deposition rate of the BPSG film according to the present invention ranged between 500 and 5000 Å/min, and the step coverage thereof was over 90%, which were both improved than the conventional BPSG film.

A PSG film was deposited at atmospheric pressure at 200 to 650°C, and disilane, TMOP or PH$_3$, and O$_2$ were flowed into the reaction chamber. Here, the step coverage of the PSG film according to the present invention was over 90%, showing much improvement compared to the conventional PSG film.

In accordance with data from Tables 3 and 4, the deposition rate and step coverage of the thin film according to present invention were improved by applying disilane to various the chemical vapor depositions for forming the thin film, because combination structure of disilane is less stable than silane ($SiH_4$) and is easily diffused at low temperatures, thus having a rapid gas diffusion rate, and accordingly a rapid deposition rate of the thin film.

As described above, the method of forming the thin film for the semiconductor device according to the present invention is capable of improving the deposition rate and step coverage of the thin film by applying disilane to the chemical vapor deposition, thereby improving productivity and reliability of the semiconductor device.

Although the preferred embodiment of the present invention has been disclosed for illustrative purposes, those skilled in the art will appreciate that various modifications, additions and substitutions are possible, without departing from the scope and spirit of the invention as recited in the accompanying claims.

## Claims

1.  In a process wherein a semiconductor substrate is put into a reaction chamber of a chemical vapor deposition equipment and the reaction chamber is maintained at predetermined pressures and temperatures, and thus a thin film is formed on the semiconductor substrate, a method of forming a thin film for a semiconductor device applying disilane as main material gas.

2.  The method of claim 1, wherein the thin film is one of oxide, nitride, nitride-oxide, borophospho silicate glass (BPSG), phospho silicate glass (PSG), and tungsten silicide films.

3.  The method of claim 2, wherein a method of forming the oxide film applies a chemical vapor deposition (CVD) equipment applying disilane and nitrogen oxide ($N_2O$).

4.  The method of claim 3, wherein the CVD equipment is a low pressure chemical vapor deposition (LPCVD) equipment, and temperatures in the reaction chamber range between 500 and 800°C and pressures are 0.1 to 9 torr.

5.  The method of claim 3, wherein the CVD equipment is a plasma chemical vapor deposition (PCVD) equipment, and temperatures in the reaction chamber range between 150 and 750°C and pressures are 0.1 to 9 torr.

6.  The method of claim 2, wherein a method of forming the oxide film applies the chemical vapor deposition (CVD) equipment applying disilane and oxygen ($O_2$).

7.  The method of claim 6, wherein the CVD equipment is the low pressure chemical vapor deposition (LPCVD) equipment, and temperatures in the reaction chamber range between 300 and 700°C and pressures are 0.1 to 9 torr.

8.  The method of claim 6, wherein the CVD equipment is an atmospheric pressure chemical vapor deposition (APCVD) equipment, and temperatures in the reaction chamber range between 200 and 650°C and pressure is atmospheric pressure.

9.  The method of claim 2, wherein a method of forming the nitride film applies the chemical vapor deposition (CVD) equipment using disilane and ammonia ($NH_3$).

10. The method of claim 9, wherein the CVD equipment is the low pressure chemical vapor deposition (LPCVD) equipment, and temperatures in the reaction chamber range between 350 and 800°C and pressures are 0.1 to 9 torr.

11. The method of claim 9, wherein the CVD equipment is the plasma chemical vapor deposition (PCVD) equipment, and temperatures in the reaction chamber range between 150 and 750°C and pressures are 0.1 to 9 torr.

12. The method of claim 2, wherein a method of forming the nitride-oxide film applies the chemical vapor deposition (CVD) equipment applying disilane, ammonia ($NH_3$), and nitrogen oxide ($N_2O$).

13. The method of claim 12, wherein the CVD equipment is the low pressure chemical vapor deposition (LPCVD) equipment, and temperatures in the reaction chamber range between 350 and 800°C and pressures are 0.1 to 9 torr.

14. The method of claim 12, wherein the CVD equipment is the plasma chemical vapor deposition (PCVD) equipment, and temperatures in the reaction chamber range between 150 and 750°C and pressures are 0.1 to 9 torr.

15. The method of claim 2, wherein a method of forming the BPSG film applies the chemical vapor deposition (CVD) equipment applying disilane, phosphine ($PH_3$), oxygen ($O_2$), and TMOB, or applying disilane, TMOP, $O_2$, and TMOB.

16. The method of claim 15, wherein the CVD equipment is the low pressure chemical vapor deposition (LPCVD) equipment, and temperatures in the reaction chamber range between 250 and 800°C and pressures are 0.1 to 9 torr.

17. The method of claim 15, wherein the CVD equipment is the plasma chemical vapor deposition (PCVD) equipment, and temperatures in the reaction chamber range between 150 and 750°C and pressures are 0.1 to 9 torr.

18. The method of claim 15, wherein the CVD equipment is the atmospheric pressure chemical vapor deposition (APCVD) equipment, and temperatures in the reaction chamber range between 200 and 650°C and pressure is atmospheric pressure.

19. The method of claim 2, wherein a method of forming the PSG film applies the chemical vapor deposition (CVD) equipment using disilane, oxygen ($O_2$), and phosphine ($PH_3$), or applying disilane, oxygen ($O_2$), and TMOP.

20. The method of claim 19, wherein the CVD equipment is the low pressure chemical vapor deposition (LPCVD) equipment, and temperatures in the reaction chamber range between 200 and 700°C and pressures are 0.1 to 9 torr.

21. The method of claim 19, wherein the CVD equipment is the plasma chemical vapor deposition (PCVD) equipment, and temperatures in the reaction chamber range between 150 and 750°C and pressures are 0.1 to 9 torr.

22. The method of claim 19, wherein the CVD equipment is the atmospheric pressure chemical vapor deposition (APCVD) equipment, and temperatures in the reaction chamber range between 200 and 650°C and pressure is atmospheric pressure.

23. The method of claim 2, wherein a method of forming the tungsten silicide film applies the chemical vapor deposition (CVD) equipment using disilane and tungstenfluoride ($WF_6$).

24. The method of claim 23, wherein the CVD equipment is the low pressure chemical vapor deposition (LPCVD) equipment, and temperatures in the reaction chamber range between 200 and 650°C and pressures are 0.1 to 9 torr.

# FIG. 1

**European Patent**
**Office**

**EUROPEAN SEARCH REPORT**

Application Number

EP 98 10 1539

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 098 865 A (MACHADO JOSE R ET AL) 24 March 1992 <br> * column 7, line 66 - column 8, line 65 * <br>--- | 1-5 | H01L21/316 <br> H01L21/314 <br> H01L21/318 <br> H01L21/285 <br> H01L21/205 |
| X | JUHO SONG ET AL: "STRUCTURAL PROPERTIES OF LOW TEMPERATURE PLASMA ENHANCED CHEMICAL VAPOR DEPOSITED SILICON OXIDE FILMS USING DISILANE AND NITROUS OXIDE" APPLIED PHYSICS LETTERS, vol. 67, no. 20, 13 November 1995, pages 2986-2988, XP000544313 <br> * the whole document * <br>--- | 1-3,5 | |
| X | EP 0 256 337 A (IBM) 24 February 1988 <br><br> * abstract * <br>--- | 1,2,23, 24 | |
| X | SAITO T ET AL: "KINETIC STUDY OF WSI-CVD PROCESSES - A COMPARISON OF WF6/SIH4 AND WF6/SI2H6 REACTION SYSTEMS" ELECTRONICS & COMMUNICATIONS IN JAPAN, PART II - ELECTRONICS, vol. 78, no. 10, 1 October 1995, pages 73-84, XP000553256 <br> * the whole document * <br>--- | 1,2,23, 24 | **TECHNICAL FIELDS SEARCHED** (Int.Cl.6) <br><br> H01L <br> C23C |
| X | JASINSJI J M ET AL: "EXCIMER LASER-INDUCED DEPOSITION OF SILICON NITRIDE THIN FILMS" JOURNAL OF APPLIED PHYSICS, vol. 61, no. 1, 1 January 1987, pages 431-433, XP000068645 <br> * the whole document * <br>--- <br><br> -/-- | 1,2,9-11 | |

The present search report has been drawn up for all claims

| Place of search | Date of completion of the search | Examiner |
|---|---|---|
| THE HAGUE | 29 June 1998 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 98 10 1539

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | DATABASE INSPEC<br>INSTITUTE OF ELECTRICAL ENGINEERS, STEVENAGE, GB<br>Inspec No. 4594953,<br>HENDA R ET AL: "Kinetics of the low pressure chemical vapor deposition of stoichiometric silicon nitride at low temperature from disilane and ammonia"<br>XP002069732<br>* abstract *<br>& JOURNAL OF CHEMICAL VAPOR DEPOSITION, JAN. 1993, USA,<br>vol. 1, no. 3, ISSN 1056-7860,<br>pages 300-314,<br>--- | 1,2,9-11 | |
| X | US 4 916 091 A (FREEMAN DEAN W ET AL) 10 April 1990<br><br>* column 5, line 13 - line 30 *<br>* column 16, line 14 - line 37 *<br>--- | 1,2,6,7,<br>15-17,<br>19-21 | |
| X | US 4 363 828 A (BRODSKY MARC H ET AL) 14 December 1982<br>* abstract *<br>--- | 1,2,6,9 | TECHNICAL FIELDS SEARCHED (Int.Cl.6) |
| A | BOZSO F ET AL: "ELECTRON-INDUCED CHEMICAL VAPOR DEPOSITION BY REACTIONS INDUCED IN ADSORBED MOLECULAR LAYERS"<br>APPLIED PHYSICS LETTERS,<br>vol. 53, no. 12, 19 September 1988,<br>pages 1095-1097, XP000069454<br>* abstract *<br>----- | 1,2,<br>12-14 | |

The present search report has been drawn up for all claims

| Place of search | Date of completion of the search | Examiner |
|---|---|---|
| THE HAGUE | 29 June 1998 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)